Europäisches Patentamt

European Patent Office

Office européen des brevets

(11) Veröffentlichungsnummer: **0 202 540**
**A1**

## (12) EUROPÄISCHE PATENTANMELDUNG

(21) Anmeldenummer: 86106228.9

(22) Anmeldetag: 06.05.86

(51) Int. Cl.4: **H01J 37/30** , G03F 1/00 , H01L 23/54

(30) Priorität: 06.05.85 DE 3516240

(43) Veröffentlichungstag der Anmeldung:
26.11.86 Patentblatt 86/48

(84) Benannte Vertragsstaaten:
AT BE CH DE FR GB IT LI LU NL SE

(71) Anmelder: **Siemens Aktiengesellschaft Berlin und München**
**Wittelsbacherplatz 2**
**D-8000 München 2(DE)**

(72) Erfinder: **Baute, Manfred**
**Böhmerwaldstrasse 58**
**D-8017 Ebersberg(DE)**

(54) **Maske für Elektronenstrahlen.**

(57) Zur Justierung, Eichung und Messung in Elektronenstrahlanlagen eingesetzte Elektronenstrahlmasken dürfen zur hochgenauen Auflösung ihrer Markierungen (4) nur einem minimalen Temperatureinfluß unterliegen. Vorgeschlagen wird eine Maske, die auf einem Substrat (1) mit äußerst niedrigem linearen thermischen Ausdehnungskoeffizienten zwei aufgedampfte strukturierte Metallschichten (2, 3) aufweist. Die Kombination der beiden Metallschichten (2, 3) gewährleistet die sichere Ableitung elektrischer Ladungen und vermeidet die Ausbildung stehender Wellen.

EP 0 202 540 A1

## Maske für Elektronenstrahlen

Die Erfindung betrifft eine Maske für Elektronenstrahlen mit Justiermarken, Eich-und Meßstrukturen nach dem Oberbegriff des Patentanspruchs 1.

Zur Strukturerzeugung auf Halbleitermaterialien werden Elektronenstrahlschreiber eingesetzt, bei denen ein Strukturmuster, z. B. für eine integrierte Schaltung, erzeugt wird.

Zur Justierung bzw. Abstimmung bei mehreren Elektronenstrahlanlagen dienen Market-Masken als Eichnormale.

Hierbei ist es notwendig, bestimmte Positionen auf dem Substrat oder dem Substrathalter erkennen zu können und diese mit großer Genauigkeit und einem hohen Signal-zu-Rausch-Verhältnis messen zu können.

Dabei wird auf einem Substrat, vorzugsweise Quarz,aufgrund seiner niedrigen thermischen Ausdehnung ein Negativlack aufgetragen, der mit Hilfe des Elektronenstrahlschreibers zunächst bestrahlt und aus dem anschließend die bestrahlten Stellen abgetragen werden. Beim anschließenden, häufig mehrfachen Einsatz als Market-Maske verbrennt durch die Bestrahlung mit Elektronen der relativ weiche Lack und außerdem muß die Maske gereinigt werden. Durch diese Beanspruchung verringert sich jedoch die Erkennbarkeit der Justiermarken und Eichstrukturen. Zusätzlich ergeben sich Justier-und Meßfehler aufgrund der noch verbleibenden Temperaturabhängigkeit vor allem des Substrats.

In der Halbleiterherstellung ist es üblich, auf einem Glas-oder Quarzsubstrat eine oder mehrere Metallschichten aufzubringen, die strukturiert sind. Aus der Patentanmeldung VPA 85 P 1054 DE ist es bekannt, zur Erzeugung von Justiermarken, Eich-und Meßstrukturen, insbesondere bei der Erzeugung von integrierten Halbleiterschaltungen in Elektronen-oder Ionenstrahlschreibern, eine mehrlagige metallische bzw. nichtmetallische Beschichtung vorzusehen, wobei das zu strukturierende Material eine relative Atommasse > 100 besitzt und auf einem elektrisch leitenden Material mit einer relativen Atommasse < 50 aufgebracht ist.

Der Erfindung liegt die Aufgabe zugrunde, eine Elektronenstrahlmaske mit Justiermarken, Eich-oder Meßstrukturen, insbesondere eine Market-Maske als Eichnormal anzugeben, bei der die Alterungsbeständigkeit und Reproduzierbarkeit der beim vorgesehenen Einsatz erhaltenen Meßwerte erhöht ist.

Diese Aufgabe wird bei einer Maske für Elektronenstrahlen der eingangs genannten Art erfindungsgemäß durch die Merkmale des kennzeichnenden Teils des Patentanspruchs 1 gelöst.

Ausgestaltungen des Erfindungsgedankens sind in Unteransprüchen gekennzeichnet.

Grundgedanke der Erfindung ist es, Justiermarken und Eichstrukturen aus einer metallischen Beschichtung eines Substrats zu erzeugen. Erfindungsgemäß wird dazu ein Material gewählt, das sehr feine Strukturen und eine hohe Beanspruchung durch Elektronenstrahlen erlaubt. Um bei der Bestrahlung mit Elektronenstrahlen -einmal zur Erzeugung der Struktur der Maske und zum anderen bei der Justierung bzw. Abstimmung oder Fehlererkennung quasi als Elektronenmikroskop - Meßfehler durch elektrische Aufladungen weitgehend zu verhindern, muß für eine gute Ableitung der durch die Bestrahlung entstehenden elektrischen Ladungen gesorgt werden. Dies geschieht vorzugsweise erfindungsgemäß durch eine zweite metallische Schicht, die unter der strukturierten Deckschicht auf der Oberfläche des Substrats aufgebracht ist und eine höhere elektrische Leitfähigkeit als die obere zu strukturierende Schicht aufweist. Zusätzlich muß diese auf der Oberfläche des Substrats liegende Metallschicht ein anderes Rückstreuverhalten gegenüber den Elektronenstrahlen aufweisen als die über ihr liegende Metallschicht, um stehende Wellen zu vermeiden. Auf diese Weise können rückgestreute Elektronenstrahlen besser absorbiert werden und eventuelle Meßfehler lassen sich verringern.

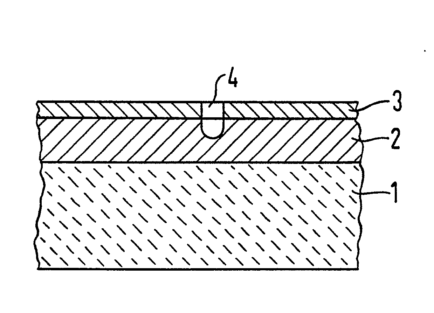

Ein erfindungsgemäßes Ausführungsbeispiel einer Maske für Elektronenstrahlen wird anhand der einzigen Figur erläutert. Auf der Oberfläche eines Substrats 1 wird zunächst eine erste metallische Schicht 2 aufgedampft, auf der wiederum eine zweite metallische Schicht 3 aufgedampft ist. Zur Strukturierung eines Grabens 4, der bis in die Metallschicht 2 reicht, wird zunächst auf der Metallschicht 3 eine Positivlackschicht aufgetragen, auf der mit Hilfe des Elektronenstrahlschreibers die zu erzeugenden Strukturen aufgestrahlt werden. Ein anschließendes, an sich bekanntes Verfahren löst diese Strukturen dann aus dem Positivlack sowie den unter ihr liegenden metallischen Schichten 3 bzw. 2 heraus.

Im Anschluß daran werden die verbleibenden Reste des maskierenden Lacks wieder entfernt.

Die Strukturierung und das Ätzen kann dabei mit den an sich bekannten Verfahren durch Elektronenstahlschreiben, reaktives Ionenätzen oder reaktives Ionenstrahlätzen durchgeführt wer-

den. Bei einer Strukturierung mittels Ionenstrahl-schreiben ist eine Lackschicht nicht erforderlich. Ebenso muß der Ätzprozeß nicht, wie in der einzigen Figur angedeutet, bei Erreichen oder kurz nach Erreichen der Metallschicht 2 gestoppt werden, so daß der Graben 4 nur bis in die oberen Schichten der Metallschicht 2 hineinreicht, sondern die Metallschicht 2 kann auch bis zur Oberfläche des Substrats 1 geätzt werden.

Vorzugsweise dauert der Ätzprozeß für die Metallschicht 3 länger als bei einer Metallschicht 2 mit vergleichbarer Dicke. Zusätzlich ist die elektrische Leitfähigkeit der Metallschicht 2 gegenüber der Metallschicht 3 höher. So kommen für die beiden Metallschichten die Kombinationen Chrom für die Metallschicht 2 und Schwarzchrom für die Metallschicht 3 sowie Gold für die Metallschicht 2 und Chrom für die Metallschicht 3 in Frage.

Der Einfluß eventueller stehender Wellen und die Feinheit der zu strukturierenden Justiermarken bzw. Eichstrukturen läßt sich über die Dicke der beiden Metallschichten beeinflussen. So wird die Metallschicht 2 vorzugsweise 80 -90 nm und die Metallschicht 3, vorzugsweise 20 -30 nm dick gewählt.

Die Maßhaltigkeit einer derartigen erfindungsgemäßen Maske und das Alterungsverhalten können zusätzlich durch die Auswahl des Substrats 1 beeinflußt werden. So kommt als Substrat 1 entweder Quarz mit einem linearen thermischen Ausdehnungskoeffizienten von etwa 5,5 $^x$ $10^{-7}$/K oder ein Glas mit niedrigem Ausdehnungskoeffizienten, zum Beispiel Low-expansion-Glas (LE-Glas) mit einem linearen thermischen Ausdehnungskoeffizienten von etwa 40 $^x$ $10^{-7}$/K in Frage.

Es liegt jedoch im Rahmen der Erfindung, für das Substrat eine Glaskeramik vorzusehen, die eine kristalline und eine Restglasphase besitzt. Die kristalline Phase besitzt eine negative, die Glasphase eine positive thermische Ausdehnung, so daß sich die lineare thermische Ausdehnung weitgehend durch die Anteile beider Phasen kompensieren läßt. So läßt sich beispielsweise eine Glaskeramik mit 70 -75 Gewichtsprozenten kristalliner Phase mit Hochquarzstruktur, die eine mittlere Kristallitgröße von 50 nm besitzt und mit einer Restglasphase von 25 -30 Gewichtsprozenten vorsehen, die einen mittleren linearen Ausdehnungskoeffizienten unter 1,8 $^x$ $10^{-7}$/K im Temperaturbereich von -160 bis +20 °C und unter 2,2 x $10^{-7}$/K im Temperaturbereich von +20 bis +300 °C aufweist. Im Temperaturbereich von 0 bis +50°C beträgt der mittlere lineare thermische Ausdehnungskoeffizient sogar nur ± 1 • $10^{-7}$/K, so daß bei Betriebstemperaturen höchstens minimale Temperatureinflüsse auftreten.

Die Kombination der beiden Metallschichten in Verbindung mit einer Glaskeramik als Substrat gewährleistet eine weitgehende Unempfindlichkeit der Maske für Elektronenstrahlen gegenüber Temperatureinflüssen, die sich möglicherweise durch nicht berücksichtigte Materialdehnungen auf die Genauigkeit der Justierung oder Eichung auswirken können. Außerdem wird mit Hilfe einer vorstehend genannten Kombination der Zeitaufwand für Justierung und Abstimmung von Elektronenstrahlanlagen erheblich reduziert.

**Ansprüche**

1. Maske für Elektronenstrahlen mit Justiermarken, Eich-oder Meßstrukturen, wie sie insbesondere in zur Herstellung integrierter Halbleiterschaltungen benutzten Elektronenstrahlanlagen verwendet werden, mit mehrlagiger strukturierter Beschichtung auf einer Oberfläche eines Substrats, **gekennzeichnet** durch zwei Metallschichten (2, 3), von denen die auf der Oberfläche des Substrats (1) liegende Metallschicht (2) eine höhere elektrische Leitfähigkeit als die über ihr liegende Metallschicht (3) besitzt.

2. Maske nach Anspruch 1, **dadurch gekennzeichnet**, daß die Metallschichten (2, 3) aufgedampft sind.

3. Maske nach Anspruch 1 bis 2, **dadurch gekennzeichnet**, daß die Metallschichten (2, 3) gegenüber den Elektronenstrahlen unterschiedliches Rückstreuverhalten besitzen.

4. Maske nach Anspruch 1 bis 3, **dadurch gekennzeichnet**, daß die Metallschichten (2, 3) unterschiedlich dick sind.

5. Maske nach Anspruch 1 bis 4, **dadurch gekennzeichnet**, daß die auf der Oberfläche des Substrats (1) liegende Metallschicht (2) dicker als die über ihr liegende Metallschicht (3) ist.

6. Maske nach Anspruch 1 bis 5, **dadurch gekennzeichnet**, daß die auf der Oberfläche des Substrats (1) liegende Metallschicht (2) 80 bis 90 nm und die über ihr liegende Metallschicht (3) 20 bis 30 nm dick ist.

7. Maske nach Anspruch 1 bis 6, **dadurch gekennzeichnet**, daß die auf der Oberfläche des Substrats (1) liegende Metallschicht (2) aus Chrom und die über ihr liegende Metallschicht (3) aus Schwarzchrom besteht.

8. Maske nach Anspruch 1 bis 6, **dadurch gekennzeichnet,** daß die auf der Oberfläche des Substrats (1) liegende Metallschicht (2) aus Gold und die über ihr liegende Metallschicht (3) aus Chrom oder Schwarzchrom besteht.

9. Maske nach Anspruch 1 bis 8, **dadurch gekennzeichnet,** daß das Substrat (1) aus Quarz oder Glas mit einem linearen thermischen Ausdehnungskoeffizienten unter $4 . 10^{-6}$ /K bezogen auf 20°C besteht.

10. Maske nach Anspruch 1 bis 8, **dadurch gekennzeichnet**, daß das Substrat (1) aus Glaskeramik mit 70 bis 80 Gew% kristalliner Phase mit Hochquarzstruktur und einer mittleren Kristallitgröße von 50 nm, einer Restglasphase von 20 bis 30 Gew%, mit einem mittleren linearen thermischen Ausdehnungskoeffizienten unter $1,8 . 10^{-7}$/K im Temperaturbereich von -160 bis +20°C, unter $2,2 . 10^{-7}$/K im Temperaturbereich von +20 bis +300°C und unter $1 . 10^{-7}$/K im Temperaturbereich von 0 bis +50°C besteht.

11. Maske nach Anspruch 1 bis 10, **dadurch gekennzeichnet,** daß die Struktur (4) der metallischen Beschichtung (2, 3) durch die oben liegende Metallschicht (3) bis in die unter ihr auf der Oberfläche des Substrats (1) liegende Metallschicht - (2) reicht.

12. Maske nach Anspruch 1 bis 10, **dadurch gekennzeichnet,** daß die Struktur (4) der metallischen Beschichtung (2, 3) durch beide Metallschichten (2, 3) bis zur Oberfläche des Substrats - (1) reicht.

13. Maske nach Anspruch 1 bis 12, **dadurch gekennzeichnet,** daß die Struktur (4) der metallischen Beschichtung (2, 3) mit an sich bekannten Trockenätzverfahren hergestellt ist.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | PATENTS ABSTRACTS OF JAPAN, Band 4, Nr. 127 (P-26) [609], 6. September 1980, Seite 55 P 26; & JP - A - 55 79 447 (DAINIPPON INSATSU K.K.) 14-06-1980 | 1,4-6 | H 01 J 37/30 G 03 F 1/00 H 01 L 23/54 |
| | --- | | |
| A | EP-A-0 082 977 (IBM) | 1-7,11 ,13 | |
| | * Seite 3, Zeilen 19-26; Seite 4, Zeile 1 - Seite 10, Zeile 29 * | | |
| | --- | | |
| A | US-A-4 139 443 (SAKURAI) | | |
| | --- | | |
| A | US-A-4 396 683 (HATANO) | | |
| | ----- | | |

RECHERCHIERTE SACHGEBIETE (Int. Cl.4)

H 01 J 37
G 03 F 1
H 01 L 23
C 03 C 10
C 03 C 4

Der vorliegende Recherchenbericht wurde für alle Patentansprüche erstellt.

| Recherchenort | Abschlußdatum der Recherche | Prüfer |
|---|---|---|
| DEN HAAG | 14-08-1986 | SCHAUB G.G. |